# EUROPEAN PATENT SPECIFICATION

(11) **EP 1 095 513 B1**
(45) Date of publication and mention of the grant of the patent: **26.03.2003**
(21) Application number: 99931125.1
(22) Date of filing: 21.06.1999
(51) Int. Cl.: H04N 5/775, H04N 5/44

(54) **METHOD FOR DRIVING A SATELLITE RECEIVER**
VERFAHREN ZUM STEUERN EINES SATELLITENEMPFÄNGERS
TECHNIQUE DE PILOTAGE D'UN RECEPTEUR DE SIGNAUX SATELLITE

(30) Priority: 30.06.1998 DE 19829022
(43) Date of publication of application: 02.05.2001
(73) Proprietor: DEUTSCHE THOMSON-BRANDT GMBH, 78048 Villingen-Schwenningen (DE)
(72) Inventor: STORZ, Achim, D-78098 Triberg (DE); BEKESI, Thomas, D-78078 Niedereschach (DE); LEUTE, Rüdiger, D-78166 Donaueschingen (DE)
(74) Representative: Rittner, Karsten, Dr.
(86) International application number: EP9904295
(87) International publication number: WO00001147

(56) References cited:
- WO-A-93/07711
- WO-A-94/17627
- WO-A-98/01993
- GB-A- 2 263 029
- US-A- 4 843 482
- US-A- 5 151 789

## Description

The invention is based on a method for driving a satellite receiver.

A television receiver, such as a video recorder, for example, is known to contain an infrared transmitting diode which enables a satellite receiver to be driven. In this case, it is disadvantageous that the user has to manually supplement programme-specific data on his video recorder, for example the programme location in the satellite receiver at which the respective programme is received. Corresponding programme information, such as show view data, can only be added manually. Such a product is known from the company Nordmende, under the name "SPECTRA V4445 SV".

It is also known for a video recorder to carry out an automatic programme search and store specific programme information, for example transmitter name, show view code or the like. At the present time, however, it is disadvantageous that such a search cannot be carried out in conjunction with an external satellite receiver.

WO-A-9307711 discloses a system in which a television receiver is functionally linked to other pieces of video equipment such as a satellite receiver or a cable box. A mode of operation is described in which the recording of a programme received through the cable box or satellite receiver is achieved by entering a code to the TV set only which are forwarded to the VCR and the cable box or satellite receiver. The code comprises a channel, date, time and length information and has to be entered by the user each time a user wants to preprogram the recording of a program.

The invention is based on the object of providing a simple method for driving a satellite receiver. This object is achieved by means of the features of the invention which are specified in Claim 1. Advantageous developments are specified in the subclaims.

In accordance with one broad aspect of the invention a method for using the programme places of a satellite receiver by means of a television receiver connected to the satellite receiver comprises the following steps:
- supplying a selection signal from the television receiver to the satellite receiver for selecting a programme place of the satellite receiver,
- tuning the satellite receiver to the selected programme place,
- transferring a tv signal received on the selected programme place from the satellite receiver to the television receiver,
- detecting a channel identifying information within the tv signal by the television receiver,
- determining the channel of the transferred signal from the channel identifying information, by the television receiver, and
- storing an information about the channel on the selected programme place of the satellite receiver in the television receiver, wherein said channel information is assigned to said selected programme place.

Television receivers are to be understood to mean apparatuses which enable television reception, even if the signal is not displayed until later on a picture display unit e.g. of a picture tube. In other words, a video recorder, a satellite decoder and also a normal television receiver with picture tube, plasma or LCD screen are to be understood as television receivers.

This system has the advantage that the user supplies the video recorder with data of the satellite receiver in a simple manner. The programme search then enables the user to perform programming in a simple manner e.g. by means of show view. Without this solution according to the invention, the data would have to be supplemented manually or programming could not be performed. If the solution according to the invention is used in a television with picture tube, this has the advantage that the user can better utilize for example the teletext system of the television receiver.

Furthermore, the method is distinguished by the fact that the programme information is assigned to the information already present in the memory of the television receiver.

In a television receiver, it is often the case that programme information is already stored in a memory, e.g. in order to perform an automatic search. It is now possible to assign the information obtained to this information. If, by way of example, the satellite receiver contains ZDF with show view code 002 at programme 2, the information is assigned to the information in the memory. If the fact that ZDF has the show view code 002 is already present in the memory, all that is added is the information that the second memory location is used in the satellite receiver and that the user can use the same memory location in the television receiver. If the intention is to retain the programme order of the television receiver, then there is stored in the memory the information that ZDF is at programme location 2 of the satellite receiver and if the television receiver wishes to keep its programme location for ZDF, e.g. the programme location 10, the satellite receiver is automatically changed over in accordance with the desired programme in the event of programming or in the event of a changeover. This means that all the apparatuses could have the same programme location order. It is also possible for the stored information and transmitter identifier to ensure that a changeover is made to the respective correct channel.

Data which are already present can be stored in a television receiver since the television receivers have been partly preprogrammed for cable and/or terrestrial reception. However, if a user uses a satellite receiver, he is generally not equipped with cable reception. Terrestrial reception is entirely possible, however. If the programme search is then started, the television receiver is advantageously assigned the same programme location as that of the satellite receiver, in order to ensure uniform location allocation. The data that were possibly stored in the memory such as e.g. show view code or transmitter name, are also assigned to the programme information in this case.

In the case of reception with a satellite receiver, the signal of the satellite receiver is normally allocated via the scart cable to the AV socket of the television receiver or fed via the RF cable, also called coax cable, to the tuner and allocated to a specific channel. The television receiver is now advantageously equipped in such a way that it performs assignments between programme location and AV or tuner channel. That means that when the user actuates the key for programme location 2 on the remote control of the television receiver, the television receiver, since it has stored the information of the order of programme locations as a result of the programme search, automatically switches the satellite receiver to programme location 2, the signal however, being communicated to it via the AV or the fixed tuner channel. In other words, the order of programme locations which the user has accepted from the satellite receiver is assigned to the respective keys, the signal, however, reaching the television receiver continually via the AV socket or the permanently assigned channel. In the normal case, the programme locations are assigned different channels, but in this case always the same channel or the same AV socket and switching over is carried out by means of the infrared driving of the television receiver. This driving could also be effected via a line if the two apparatuses, in addition to data transmission in one direction, also have a line for data transmission in the other direction.

It will be conceivable for signals to be modulated onto the RF or scart cable, thereby also enabling date transmission to be performed in this way. In another solution, a special control line is used for data exchange. The use of infrared signals constitutes a universal solution in which the television has an infrared transmitting diode which thus controls the search of the satellite receiver. For this purpose, a multiplicity of infrared codes of satellite receivers should be stored in the television receiver, or it should be possible to add additional codes for new types of satellite receivers whose code is not yet stored in the television receiver. The codes could be added by means of an acoustic coupling - by way of example, a service number is called which then transfers the data to an interface in the television receiver by telephone. For this purpose, the interface must be equipped with a microphone, which may also be formed by the loudspeaker in the television receiver, picks up the acoustic signals and then converts them into code information for the television receiver with the aid of the control unit. It is also possible for this service information to be transmitted via a special channel in order thus to update the television receiver with current codes.

The method is also distinguished by the fact that the programme information, such as teletext information, is updated.

In current television receivers which display teletext information, it happens that teletext pages are not updated in the event of a programme change. This is due to the fact that, as a rule, the satellite receiver is connected to the television receiver by a cable, as described above, and transmits the respective programme to the television receiver via the cable. The television receiver does not, as a rule, note whether a programme change has taken place in the satellite receiver. This is noted only if the transmitter information is concomitantly read out as well, as a result, the method according to the invention makes it possible, in the event of detection of a transmitter change, to erase or to update the pages stored in the teletext memory.

Furthermore, the method is distinguished by the fact that the programme information, such as show view data and/or transmitter name, is stored in the memory.

The user now has the advantage that he does not have to add information such as show view data or transmitter names manually, rather these are stored automatically.

The method is also distinguished by the fact that the memory is formed from a plurality of memories or memory levels.

In the case of the memory, it is possible for it to be divided into a plurality of levels or for a plurality of memories to be used, in order to enable better data exchange or to configure the system such that it can be built up.

A circuit for driving a satellite receiver with a control unit, a data channel, a television receiver control unit and a memory, is distinguished by the fact that the television receiver control unit drives the satellite receiver control unit via the data channel and carries out a programme search, with the result that the programme information of the respective programme is stored in the memory of the television receiver for the respective corresponding programme of the television receiver. Furthermore, the circuit is distinguished by the fact that the data channel is formed without a cable or through cable.

The invention is explained below with reference to the drawings. Identical reference symbols indicate identical functioning. In the figures:
- Figure 1: shows a block diagram according to the invention with a video recorder as the television receiver,
- Figure 2: shows a block diagram according to the invention with a television, and
- Figures 3-6: show an arrangement of equipment and various menu displays.

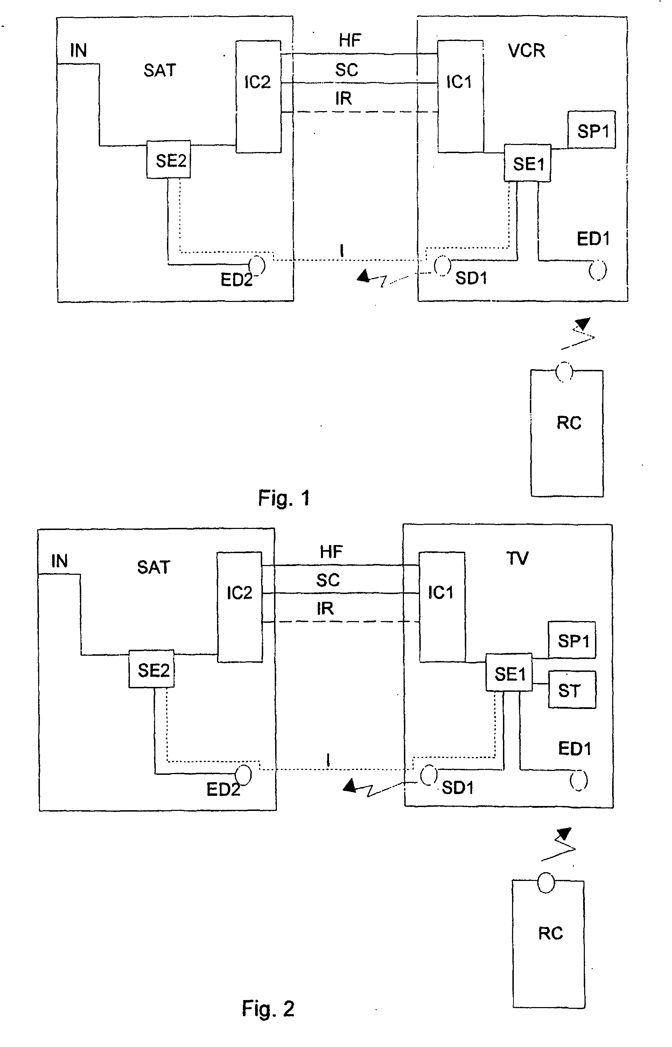

Figure 1 shows a block diagram according to the invention with a satellite receiver SAT and a video recorder VCR as the television receiver. The satellite input signal IN passes to the control unit SE2 of the satellite receiver SAT and from there to the integrated circuit IC2. The integrated circuit is connected to transmission media, such as a radio-frequency cable HF, a scart cable SC or to an optical control transmission unit, represented by a dashed line in this case. The integrated circuit IC2 may comprise a plurality of circuits, not illustrated here, or be constructed in such a way that the corresponding information is conditioned appropriately for the form of transmission. At the remote end the video recorder VCR has a similarly configured integrated circuit IC1, which is connected to a control unit SE1. The control unit SE1 is connected to the memory SP1. The memory SP1 may be formed by a plurality of memories or be subdivided into a plurality of memory levels, not illustrated here. The control unit SE1 is driven by the remote control RC via the receiver diode ED1. The control unit SE1 exchanges information with other connected apparatuses via the integrated circuit IC1 or via the transmitting diode SD1. The control information of the transmitting diode SD1 passes to the receiving diode ED2 of the satellite receiver SAT and from there to the control unit SE2. The control information could also be passed to the satellite receiver SAT via a data line or a bus system, indicated by the line I in this case.

If, by way of example, a programme search is carried out by the method according to the invention, it is activated by means of the remote control or by means of a key on the video recorder, not illustrated here. The control unit SE1 then communicates, via the transmitting diode SD1, the control information that the satellite receiver ought to switch to its first programme location. The information of the switching over is forwarded to the control unit SE2 via the receiving diode ED2, which is present in any case in the satellite receiver. Satellite receivers are, as a rule, programmed at the time of manufacture. If this is not the case, then a search is automatically started in the satellite receiver, since the control unit SE2 notes that no information is received at the first programme location and thus starts a search.

If it is assumed, in the normal case, ARD is received at the first programme location in the satellite receiver, the programme information is transferred from the integrated circuit IC2 via the connection types HF, SC, IR already mentioned to the integrated circuit IC1, from where the control unit SE1 of the video recorder can evaluate the programme information. The data desired in that case, such as e.g. show view, programme names or the like, are stored in the memory SP1. Afterwards, the control unit SE1, via the transmitting diode SD1, instructs the receiving diode ED2 and the control unit SE2 to change to the second programme location. As a rule, ZDF is then received and storage proceeds in the manner already explained in the ARD example. Thus, a search is then carried out for all programmes received by the satellite receiver. The user may preferably follow the search on the television screen connected to the video recorder and, if appropriate, abort it if audio programmes are found or if encrypted television programmes are received.

Figure 2 shows a block diagram according to the invention with a television. The method of operation is identical to the method of operation described in Figure 1. Since the television is also provided with a teletext page memory ST, it is now possible to store additional teletext information. In other words, in the event of switching over from one programme location to the next, the corresponding teletext information is renewed in the teletext page memory ST. The pages are always thus updated. If the user then calls up teletext page 333 on his television TV, this can be performed effortlessly with the remote control of the television. In current televisions, although it is possible to use the remote control of the television receiver TV to call up the teletext page, driving the satellite receiver SAT is not possible. This would only be possible if the television had a universal remote control driving the satellite receiver on the one hand, and the television on the other hand, in which case updating of the memory contents would still not thereby be provided.

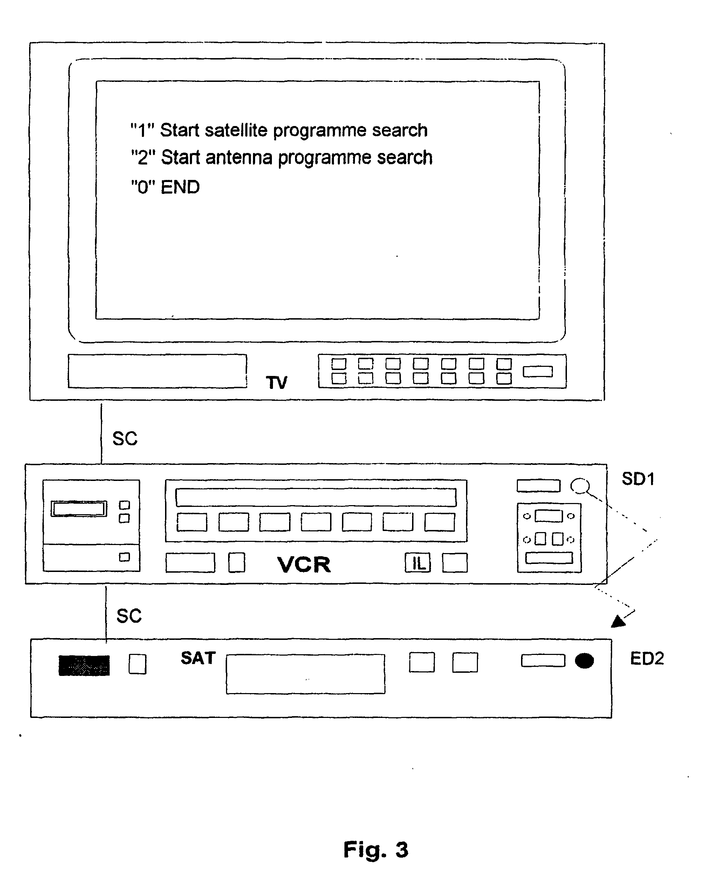

Figure 3 shows a television TV connected to the video recorder VCR via the scart cable SC. The video recorder VCR is in turn connected to the satellite receiver SAT via the scart cable SC. If the user presses the Install key IL on the video recorder VCR or on the remote control of the video recorder, not illustrated here, the menu appears, displayed on the screen of the television TV. Depending on which key the user then presses, the corresponding task is performed. By way of example, if he presses key 1, the satellite programme run starts, that is to say the transmitting diode SD1 of the video recorder VCR communicates to the satellite receiver SAT, to the receiving diode ED1 thereof, that the said receiver ought to switch to its programme location 1. The driving by means of an infrared signal from the video recorder is possible in the case of models from the same manufacturer by virtue of the fact that the video recorder contains the infrared code necessary for driving the satellite receiver. If this is not the case, a search is carried out, since the video recorder contains infrared codes for almost all satellite receivers. If the transmitting diode SD1 forwards the command for switching over to the first programme location to the satellite receiver SAT and the video recorder VCR does not receive a signal via the scart cable SC, the said video recorder will automatically carry out the search internally, thereby finding the corresponding infrared code for the receiving diode ED2 of the satellite receiver SAT. Once this setting has been performed, the actual programme search can be begun.

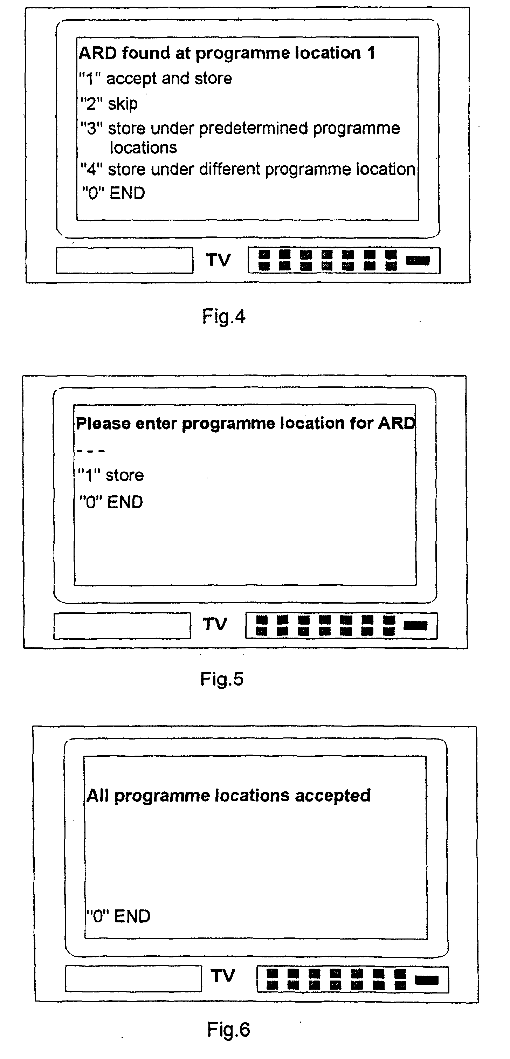

Figure 4 shows that, by way of example, ARD has been found at programme location 1. The user can then accept and store the programme location thus chosen using key 1. He can skip this programme using key 2, store the programme under a predetermined programme location using key 3, and store the programme under a different programme location using key 4. Predetermined programme locations are specified by the manufacturer, for example, in the way that a video recorder is generally programmed. This predetermined specification might read as follows: Programme location 1 - ARD, Programme location 2 - ZDF, Programme location 3 - N3, etc. This predetermined specification is used inter alia even if the user started the antenna programme search using key 2 in the first menu from Figure 3. This predetermined specification means that subsequent sorting is no longer necessary. The user can now decide whether he would like to have freely selectable programming, partly predetermined programming or the same programming of his satellite system. These predetermined programming specifications are very helpful, depending on the components. Thus, e.g. in the case of an inexpensive satellite receiver, the programmes are in some instances optionally stored, the user thereby gaining a better overview of the predetermined programme locations.

If the user pressed key 4, illustrated in Figure 4, he is shown a screen like the one illustrated in Figure 5. The user is then requested to allocate a programme location number. He stores the information using key 1 and ends this operation using key 0. If all the programme locations have been assigned, whether by way of a satellite programme search or antenna programme search, the user is shown this, as illustrated in Figure 6. He can then leave this menu by actuating key 0, or the menu switches itself off automatically after a few seconds.

Figures 3, 4, 5 and 6 illustrate only by way of example a menu in which the user has to press the function keys of the remote control. It would also be conceivable for the individual commands to be contrasted with one another in colour and the user to use a cursor to steer from one menu item to another and, by way of example, to cause this menu item to be executed by means of an Enter key.

## Claims

1. Method for using the programme places of a satellite receiver (SAT) by means of a television receiver (VCR, TV) connected to the satellite receiver, comprising the following steps,
- supplying a selection signal from the television receiver to the satellite receiver for selecting a programme place of the satellite receiver,
- tuning the satellite receiver to the selected programme place,
- transferring a tv signal received on the selected programme place from the satellite receiver to the television receiver,
**characterized by** the following steps:
- detecting a channel identifying information within the tv signal by the television receiver,
- determining the channel of the transferred signal from the channel identifying information, by the television receiver,
- storing an information about the channel on the selected programme place of the satellite receiver in the television receiver, wherein said channel information is assigned to said selected programme place.

2. Method according to claim 1, further comprising:
- selecting a channel in response to a user input,
- determining the satellite receiver programme place of the selected channel from the stored channel information in the television receiver,
- transferring a signal comprising the satellite receiver programme place from the television receiver to the satellite receiver, and
- switching the satellite receiver to said satellite receiver programme place.

3. Method according to claim 2, wherein the programme place of the satellite receiver is assigned to the programme place of the television receiver and a corresponding information is stored in the television receiver.

4. Method according to claim 3, wherein for selection of a programme place of the television receiver the satellite receiver is switched to the corresponding programme place.

5. Method according to any of the preceding claims, wherein teletext information is updated in case of a channel change recognized by a changed channel identifying information.

6. Method according to any of the preceding claims, wherein the television signal transferred from the satellite receiver to the television receiver comprises the channel identifying information.

7. Method according to any of the preceding claims, wherein the television receiver supplies at first a signal to the satellite receiver to switch to the first programme place, then after storing of the channel information the television receiver supplies a signal to the satellite receiver to switch to the second programme place and so on.

8. Method according to any of claims 1 to 6, wherein a programme search is started in the satellite receiver upon reception of the signal supplied by the television receiver.

9. Method according to claim 8, wherein the programme search is automatically started if no signal is received at the first programme place.

10. Method according to any of the preceding claims, wherein the television receiver is a video recorder.

## Patentansprüche

1. Verfahren zur Benutzung der Programmplätze eines Satellitenempfängers (SAT) durch einen Fernsehempfänger (VCR; TV), der mit dem Satellitenempfänger verbunden ist, mit folgenden Schritten:
- Zuführung eines Auswahlsignals von dem Fernsehempfänger zu dem Satellitenempfänger zur Auswahl eines Programmplatzes des Satellitenempfängers,
- Abstimmung des Satellitenempfängers auf den gewählten Programmplatz,
- Übertragung eines auf dem gewählten Programmplatz empfangenen Fernsehsignals von dem Satellitenempfänger zu dem Fernsehempfänger,
**gekennzeichnet durch** folgende Schritte:
- Detektierung einer Kanal-Identifizierungs-Information in dem Fernsehsignal **durch** den Fernsehempfänger,
- Ermittlung des Kanals des übertragenen Signals aus den Kanal-ldentifizierungs-Informationen **durch** den Fernsehempfänger,
- Speicherung einer Information über den Kanal auf dem gewählten Programmplatz des Satellitenempfängers in dem Fernsehempfänger, wobei die Kanalinformationen dem gewählten Programmplatz zugeordnet werden.

2. Verfahren nach Anspruch 1 mit:
- Wahl eines Kanals aufgrund einer Benutzereingabe,
- Ermittlung des Programmplatzes des Satellitenempfängers des gewählten Kanals aus den in dem Fernsehempfänger gespeicherten Kanalinformationen,
- Übertragung eines Signals mit dem Programmplatz des Satellitenempfängers von dem Fernsehempfänger zu dem Satellitenempfänger und
- Umschaltung des Satellitenempfängers auf den Programmplatz des Satellitenempfängers.

3. Verfahren nach Anspruch 2, wobei der Programmplatz des Satellitenempfängers dem Programmplatz des Fernsehempfängers zugeordnet wird und eine entsprechende Information in dem Fernsehempfänger gespeichert wird.

4. Verfahren nach Anspruch 3, wobei für die Wahl eines Programmplatzes des Fernsehempfängers der Satellitenempfänger auf den entsprechenden Programmplatz umgeschaltet wird.

5. Verfahren nach einem der vorangehenden Ansprüche, wobei die Teletextinformationen im Fall eines Kanalwechsels aktualisiert werden, der durch eine Identifizierungsinformation für den geänderten Kanal erkannt wird.

6. Verfahren nach einem der vorangehenden Ansprüche, wobei das von dem Satellitenempfänger zu dem Fernsehempfänger übertragene Fernsehsignal die Kanal-Identifizierungsinformation enthält.

7. Verfahren nach einem der vorangehenden Ansprüche, wobei der Fernsehempfänger zunächst ein Signal zu dem Satellitenempfänger für die Umschaltung auf den ersten Programmplatz liefert, dann nach dem Speichern der Kanalinformation der Fernsehempfänger ein Signal zu dem Satellitenempfänger für die Umschaltung auf den zweiten Programmplatz liefert undsoweiter.

8. Verfahren nach einem der Ansprüche 1 bis 6, wobei ein Programmsuchvorgang in dem Satellitenempfänger aufgrund des Empfangs des durch den Fernsehempfänger gelieferten Signals gestartet wird.

9. Verfahren nach Anspruch 8, wobei der Programmsuchvorgang automatisch gestartet wird, wenn bei dem ersten Programmplatz kein Signal empfangen wird.

10. Verfahren nach einem der vorangehenden Ansprüche, wobei der Fernsehempfänger ein Videorekorder ist.

## Revendications

1. Technique d'utilisation des emplacements de programmes d'un récepteur de signaux satellite (SAT) à l'aide d'un récepteur de télévision (VCR, TV) relié à un récepteur de signaux satellite comprenant les étapes suivantes :
- transmission d'un signal de sélection du récepteur de télévision au récepteur de signaux satellite pour sélection d'un emplacement de programmes du récepteur de signaux satellite,
- réglage du récepteur de signaux satellite sur l'emplacement de programmes sélectionné,
- transfert d'un signal tv reçu sur l'emplacement de programmes sélectionné depuis le récepteur de signaux satellite vers le récepteur de télévision,
**caractérisée par** les étapes suivantes :
- détection d'un canal identifiant les informations dans le signal tv par le récepteur de télévision,
- détermination de la voie du signal transféré depuis la voie identifiant les informations par le récepteur de télévision,
- stockage d'informations sur le canal sur l'emplacement de programmes sélectionné du récepteur de signaux satellite dans le récepteur de télévision où lesdites informations sur le canal sont affectées audit emplacement de programmes sélectionné.

2. Technique conforme à la revendication 1, comprenant en outre :
- la sélection d'un canal en réponse à une entrée utilisateur,
- la détermination de l'emplacement de programmes du récepteur de signaux satellite du canal sélectionné depuis les informations relatives à la voie stockées dans le récepteur de télévision,
- le transfert d'un signal comprenant l'emplacement de programmes du récepteur de signaux satellite depuis le récepteur de télévision vers le récepteur de signaux satellite, et
- commutation du récepteur de signaux satellite vers ledit emplacement de programmes du récepteur de signaux satellite.

3. Technique conforme à la revendication 2, où l'emplacement de programmes du récepteur de signaux satellite est affecté à l'emplacement de programmes du récepteur de télévision et des informations correspondantes sont stockées dans le récepteur de télévision.

4. Technique conforme à la revendication 3, où pour la sélection d'une plage d'emplacements de programmes du récepteur de télévision, le récepteur de signaux satellite est commuté vers l'emplacement de programmes correspondant.

5. Technique conforme à n'importe laquelle des revendications précédentes où les informations du télétexte sont mises à jour en cas de modification d'un canal reconnu par des informations d'identification d'un canal modifié.

6. Technique conforme à n'importe laquelle des revendications précédentes où le signal de télévision transféré du récepteur de signaux satellite au récepteur de télévision comprend les informations d'identification d'un canal.

7. Technique conforme à n'importe laquelle des revendications précédentes où le récepteur de télévision fournit en premier lieu un signal au récepteur de signaux satellite pour commuter au premier emplacement de programmes, puis après stockage des informations sur le canal, le récepteur de télévision fournit un signal au récepteur de signaux satellite pour commuter vers le second emplacement de programmes, etc.

8. Technique conforme à n'importe laquelle des revendications 1 à 6 où une recherche de programmes est lancée dans le récepteur de signaux satellite à la réception du signal fourni par le récepteur de télévision.

9. Technique conforme à la revendication 8 où la recherche de programmes est automatiquement lancée si aucun signal n'est reçu au niveau du premier emplacement de programmes.

10. Technique conforme à n'importe laquelle des revendications précédentes où le récepteur de télévision est un magnétoscope.
